# EUROPEAN PATENT SPECIFICATION

(11) **EP 4 563 850 B1**
(45) Date of publication and mention of the grant of the patent: **04.11.2026**
(21) Application number: 23212659.9
(22) Date of filing: 28.11.2023
(51) Int. Cl.: F16J 15/02, H05K 5/06, F16J 15/00, F16J 15/10

(54) **GASKET SYSTEM FOR AN ELECTRIC DEVICE AND ELECTRIC DEVICE**
DICHTUNGSSYSTEM FÜR EIN ELEKTRISCHES GERÄT UND ELEKTRISCHES GERÄT
SYSTÈME DE JOINT D'ÉTANCHÉITÉ POUR UN DISPOSITIF ÉLECTRIQUE ET DISPOSITIF ÉLECTRIQUE

(43) Date of publication of application: 04.06.2025
(73) Proprietor: Hitachi Energy Ltd, 8050 Zürich (CH)
(72) Inventor: USAREK, Krzysztof, 30-716 Krakow (PL); SBRAVATI, Alan, Raleigh, 27610 (US)
(74) Representative: Epping - Hermann - Fischer

(56) References cited:
- US-A1- 2001 040 037
- US-A1- 2007 159 774

## Description

The present disclosure relates to an electric device with a gasket system.

Gaskets are used in electric devices to avoid leakage of fluids used during operation of the electric devices.

US 2007/159774 A1 discloses a sealed electro-technical device, according to the preamble of claim 1, with a first sealing joint and a second sealing joint and a barrier element positioned between the sealing joints. The barrier element is permeable with respect to a fluid in the device and impermeable with respect to a sealing substance. US 2001/040037 A1 discloses a radio communication equipment with a string-type waterproof packing provided at an opening of an equipment body and, a string-type water absorber composed of material having greater elastic contractibility than that of the waterproof packing.

One object to be achieved is to provide an electric device with a gasket system which contributes to a reliable prevention of leakage of the electric device.

According to an embodiment of the electric device with the gasket system, the gasket system comprises a gasket which is configured to be non-permeable for an insulating fluid used for the operation of the electric device. The gasket system further comprises an imbibing material which is configured to absorb the insulating fluid used for the operation of the electric device. The gasket and the imbibing material are arranged one after the other in a region of the electric device, which is to be sealed so that, if the insulating fluid used for the operation of the electric device passes one of the gasket and the imbibing material, the insulating fluid will hit the respective other one of the gasket and the imbibing material. The gasket and the imbibing material are arranged such that the insulating fluid used for the operation of the electric device has to first pass the gasket before it hits the imbibing material, wherein the imbibing material is configured to absorb the insulating fluid in case of leakage through the gasket, thereby to prevent leakage of the insulating fluid out of the electric device.

While the cost of gaskets usually represents less than 1% of the costs of an electric device, the costs associated with fixing damage caused by impacts and repairing leaks represent a much larger portion of the warranty expenses for a company. Regardless of the quality controls on the gasket materials and the device production, there are still a number of cases every year in which electric devices leak insulating fluid. Due to the increasing relevance of environmental aspects, customers are not only far more sensitive to such issues, but also want immediate action to repair and eliminate the effects of these leaks. This results in major costs for a company.

The present invention is, inter alia, based on the recognition that using an imbibing material in addition to a gasket will prevent leakage much more reliably, therefore saving costs and protecting the environment.

The gasket is formed of a tight or non-permeable material. It may be formed of a non-absorbing material. Properties like tight, permeable, imbibing or absorbing herein refer to the insulating fluid, if not stated otherwise. The gasket may be a solid element. It may be formed in one piece. For example, the gasket is ring-shaped. The gasket may be a tube or a band. For instance, the gasket is elastic so that it can be compressed between two elements in order to increase the sealing properties of the gasket.

The gasket is configured to be non-permeable for the insulating fluid. This means that the gasket is non-permeable or at least is meant to be non-permeable. Still, a certain amount of the insulating fluid may pass the gasket due to aging effects or damage or non-perfect placement in the electric device.

The imbibing material is configured such that it absorbs or imbibes, respectively, the insulating fluid. For example, the imbibing material is configured such that it expands or swells, respectively, when it absorbs the insulating fluid. In this way, it is expected to/will clog a leakage path. Accordingly, the gasket system is a self-healing gasket system.

The imbibing material may be provided in one extended, contiguous and solid element or as a plurality of individual beads or fibers. The imbibing material may comprise a polymer/plastic or consist thereof. Imbibing materials for different fluids, like hydrocarbons, are on the market and are known to the skilled person. For example, the imbibing material comprises or consists of styrene, pentadiene, cyclopentadiene, butylene, ethylene, isoprene, butadiene, propylene or mixtures of such polymers.

The imbibing material may be mixed with another material which, for example, is non-absorbent for the insulating fluid. For instance, the other material is rubber,

The imbibing material and the gasket are arranged one after the other so that the insulating fluid flowing along a potential leakage path has to pass both the gasket and the imbibing material, namely one after the other. The gasket and the imbibing material can thereby be handled individually and independently from each other. Particularly, the gasket and the imbibing material are at least two separate structures. The imbibing material is not part of the gasket or incorporated therein. For example, the gasket is free of any absorbing/imbibing material.

The insulating fluid used for the operation of the electric device is, for instance, electrically insulating. For example, the insulating fluid is an organic fluid.

The gasket and the imbibing material are arranged such that, if the insulating fluid used for the operation of the electric device passes the gasket, it will hit the imbibing material. In other words, along the potential leakage path, the gasket is arrangeable in front of the imbibing material so that, in the case of an imminent leakage, the insulating fluid has to first pass the gasket before it hits the imbibing material. That is, the gasket can be arranged closer to the reservoir containing the insulating fluid than the imbibing material. Thus, during normal operation of the electric device, if the gasket seals sufficiently well, the imbibing material does not come into contact with the insulating fluid.

According to a further embodiment, the imbibing material is configured to imbibe organic fluids, like hydrocarbons, particularly oil.

According to a further embodiment, the imbibing material is incorporated in an imbibing structure which can be handled separately from the gasket. The imbibing structure and the gasket are, in particular, solid elements which can be handled separately. Since the imbibing material can be realized by an imbibing structure or can at least be incorporated into an imbibing structure, all features disclosed in connection with the imbibing material are also disclosed for the imbibing structure and vice versa. This is valid, in particular, for the arrangement of the imbibing material/structure with respect to the gasket or other elements.

According to a further embodiment, the imbibing structure is a fabric. The fabric contains the imbibing material. For example, the fibers of the fabric consist of the imbibing material. Alternatively, the imbibing material may be embedded between fibers of the fabric. In this case, the fabric may be formed of woven or non-woven synthetic fibers, which are non-absorbent for the insulating fluid.

According to a further embodiment, the imbibing structure is a ribbon. The ribbon may be formed of the fabric specified above. Particularly, the imbibing structure is flexible. For instance, in the ribbon, the imbibing material in the form of fibers or beads constitutes a binder mixed with rubber.

According to a further embodiment, the thickness of the imbibing structure is smaller than the thickness of the gasket. Herein, the thickness of an element is, in particular, its diameter. For example, when the imbibing structure is a ribbon, a thickness measured perpendicularly to its main extension direction is smaller than the thickness of the gasket. The thickness of the gasket is also measured perpendicularly to its main extension direction. For example, the thickness of the imbibing structure is at most 80% or at most 50% of the thickness of the gasket. Since the imbibing material swells when it absorbs the insulating fluid, its diameter increases so that it will clog the potential leakage path.

According to a further embodiment, the gasket system comprises a sensor. The sensor is configured to detect the insulating fluid. For example, the sensor is a moisture sensor. The sensor may be configured to generate an electrical signal, which is representative of whether the insulating fluid has been detected or not. The electrical signal can then be used to indicate to a user or operator of the electric device that the insulating fluid has been detected. For example, the sensor or at least a probe thereof, is arrangeable between the gasket and the imbibing material.

According to a further embodiment, the imbibing material is provided in the form of beads and/or fibers. The beads or fibers, respectively, may consist of the imbibing material. The beads or fibers may be provided as individual and unconnected beads or fibers, for example in the form of a gross powder. Alternatively, the beads or fibers may be interconnected with each other, for example when incorporated into a fabric as binders. For example, the beads have diameters of at most 2 mm or at most 0.1 mm. The diameter of the fibers may be in the same range or smaller. The lengths of the fibers may be at most 5 mm or at most 1 mm.

According to a further embodiment, the imbibing material is configured to expand or swell when it absorbs the insulating fluid. For example, the imbibing material is configured such that it can absorb the insulating fluid until the volume of the imbibing material has increased by a factor of at least 2 or at least 10 and/or of at most 30 or at most 15. Particularly, when the imbibing material is provided in the form of beads or fibers, the size/volume of the beads or fibers can increase by at least a factor of 2 or 10 and/or of at most 30 or at most 15 when absorbing the insulating fluid.

According to a further embodiment, the fibers of the insulating material are configured to expand their size, e.g. become longer, and solidify when imbibed with the insulating fluid. This means, in particular, that the fibers become rigid when absorbing the insulating fluid so that a mesh of fibers becomes rigid when the insulating fluid is absorbed.

According to a further embodiment, the gasket comprises or consists of at least one of: cork, rubber.

According to an embodiment, the electric device comprises a first element and a second element arranged on the first element and spaced apart from the first element such that a gap is formed between the first and the second element. The electric device further comprises the gasket system according to any of the embodiments described herein. The gasket system is arranged in the gap and configured to prevent the passage of an insulating fluid used for the operation of the electric device through the gap.

The first and the second element may be formed of metal. For example, the first element is a housing of the electric device in which the insulating fluid is stored or through which the insulating fluid is flowing. The second element may be a cover or a shutter or another element used for closing an opening in the first element.

The gap between the first and second element may have a height, measured in a first direction. The height is, for example, at most 5 cm or at most 2 cm or at most 1 cm. The first direction is, in particular, the direction from the first element to the second element. The height of the gap may lie in the range of 0.6 times to 0.8 times the diameter/thickness of the gasket (in its uncompressed state).

A width of the gap is measured in a second direction which is perpendicular to the first direction. The width is, in particular, greater than the height, e.g. at least two times as great as the height. The width of the gap may lie in the range of 1.5 times to 2.5 times the diameter/thickness of the gasket (in its uncompressed state).

The gap may be formed groove-like. For instance, the gap has a length, measured in a third direction which is perpendicular to the first direction and perpendicular to the second direction. The length is, for instance, larger than the height and the width. For example, the length of the gap is at least 5 times or at least 10 times greater than the height and/or the width. The gap may be ring-shaped or may be formed as a frame, i.e. it may form a closed loop. In this case, the third direction is a direction circumferentially along the ring or frame, respectively. The length is then equal to the circumference of the closed loop.

For example, in the second direction, the gasket and the imbibing material are arranged one behind the other in the gap. The gasket and the imbibing material may be spaced apart from each other in the second direction. The space between the imbibing material and the gasket in the second direction is, for example, free, i.e. only filled with gas. The space may be at least 1 cm, for example.

The thickness/diameter of the gasket may be equal to the height of the gap so that the gasket completely overbridges the gap in the first direction. The gasket may be flexible and may be compressed in the first direction. In other words, the thickness of the gasket in an uncompressed state is larger than the height of the gap. For example, in the gap, the gasket is compressed by at least 10% and/or at most 40%, particularly by 25%. The thickness of the imbibing material or the imbibing structure is, for example, smaller than the height of the gap.

The gasket and/or the imbibing material may extend over the whole length of the gap.

According to a further embodiment, the sensor of the gasket system or at least the probe of the sensor is arranged in the gap. For example, in the second direction, the sensor or the probe is arranged between the gasket and the imbibing material.

According to a further embodiment, an opening is formed in the first element. The opening may be completely surrounded by the first element. The above defined third direction may be a direction circumferentially around the opening. For example, the opening is provided for maintenance activities and/or for extracting or filling the insulating fluid out of or into the electric device. In top view onto the opening, the opening may be completely covered by the second element. For example, the second element projects beyond the opening in the above defined second direction.

According to a further embodiment, the first element is configured to receive an insulating fluid during the operation of the electric device.

According to a further embodiment, the gasket is arranged closer to the opening than the imbibing material. For example, in the second direction, the gasket is arranged between the imbibing material and the opening.

According to a further embodiment, the gasket surrounds the opening. For example, the gasket completely surrounds the opening. In this case, the gasket may be formed as a frame or a ring around the opening.

According to a further embodiment, the imbibing material surrounds the opening and the gasket. For example, the imbibing material completely surrounds the opening and the gasket. In this case, the imbibing material may be arranged in the form of a ring or frame around the opening and the gasket.

According to a further embodiment, in the first direction, the gap is delimited by the first and the second element. Particularly, the height of the gap is defined by the distance of the first and the second element in the first direction.

According to a further embodiment, in the second direction, the gap is delimited by a third and a fourth element. Particularly, the width of the gap may be defined by the distance between the third and the fourth element in the second direction.

According to a further embodiment, in the first direction, the gasket and the imbibing material are arranged between the first and the second element. In the second direction, the gasket and the imbibing material are arranged between the third and the fourth element.

According to a further embodiment, the electric device is a power electric device. For example, the electric device is a power transformer.

According to a further embodiment, the first element is a tank frame of the electric device. Alternatively, the first element may be a flange or a cover.

According to a further embodiment, the second element is a cover or an electric component, like a valve or a bushing or a sensor. Alternatively, the second element could also be a blind flange.

According to a further embodiment, the third and the fourth elements are welded bars. Alternatively, the third and/or the fourth element could also be sides delimiting a groove, particularly a machined groove. In this case, the first element and/or the second element may be the bottom of the groove.

Hereinafter, the gasket system and the electric device will be explained in more detail with reference to the drawings on the basis of exemplary embodiments. The accompanying figures are included to provide a further understanding. In the figures, elements of the same structure and/or functionality may be referenced by the same reference signs. It is to be understood that the embodiments shown in the figures are illustrative representations and are not necessarily drawn to scale. Insofar as elements or components correspond to one another in terms of their function in different figures, the description thereof is not repeated for each of the following figures. For the sake of clarity, elements might not appear with corresponding reference symbols in all figures.
Figures 1 and 2 show an exemplary gasket system in two different views,
Figures 3 to 5 show an exemplary embodiment of the electric device in different situations,
Figure 6 shows a second exemplary embodiment of the electric device,
Figure 7 shows a third exemplary embodiment of the electric device, and
Figure 8 shows a fourth exemplary embodiment of the electric device.

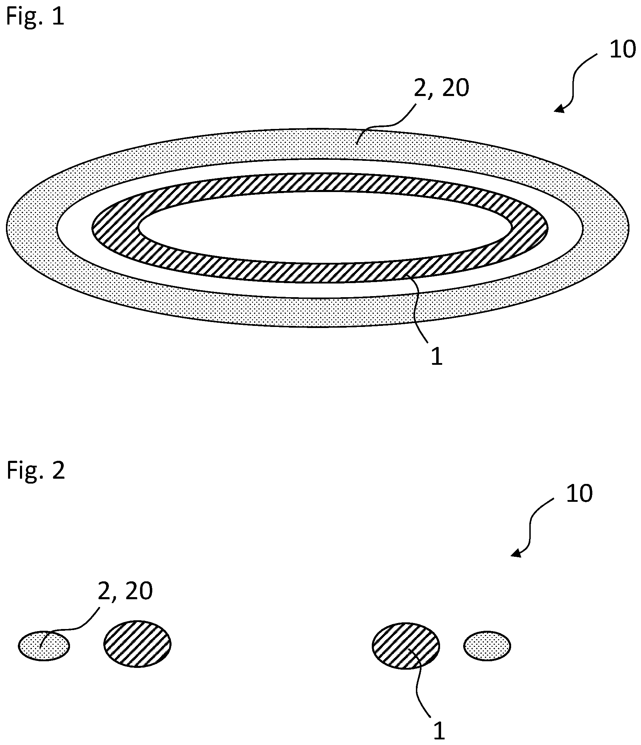

An example of a gasket system which can be part of an embodiment of an electric device in a perspective view is shown in figure 1. A cross-sectional view of this exemplary gasket system 10 is shown in figure 2. The gasket system 10 comprises a gasket 1 and an imbibing structure 20 comprising an imbibing material 2. The gasket 1 is formed as a ring and consists, for example, of cork or rubber. The imbibing structure 20 is a ribbon arranged ring-like around the gasket 1. The imbibing structure 20 comprises, for example, a fabric in which the imbibing material 2 is incorporated or which consists of the imbibing material 2. The imbibing material 2 may be beads of fibers of a polymer. The imbibing material 2 is configured to absorb an insulating fluid, particularly a hydrocarbon, like oil.

As can be seen in figure 2, the cross-sections of the gasket 1 and the imbibing structure 20 are both oval or round. The thickness/diameter of the imbibing structure 20 is thereby smaller than the thickness/diameter of the gasket 1.

In contrast to what is shown in figures 1 and 2, the imbibing material 2 could also be provided in the form of a gross powder of a plurality of unconnected beads of fibers. This gross powder can be sprinkled around the gasket 1, for example in a ring form.

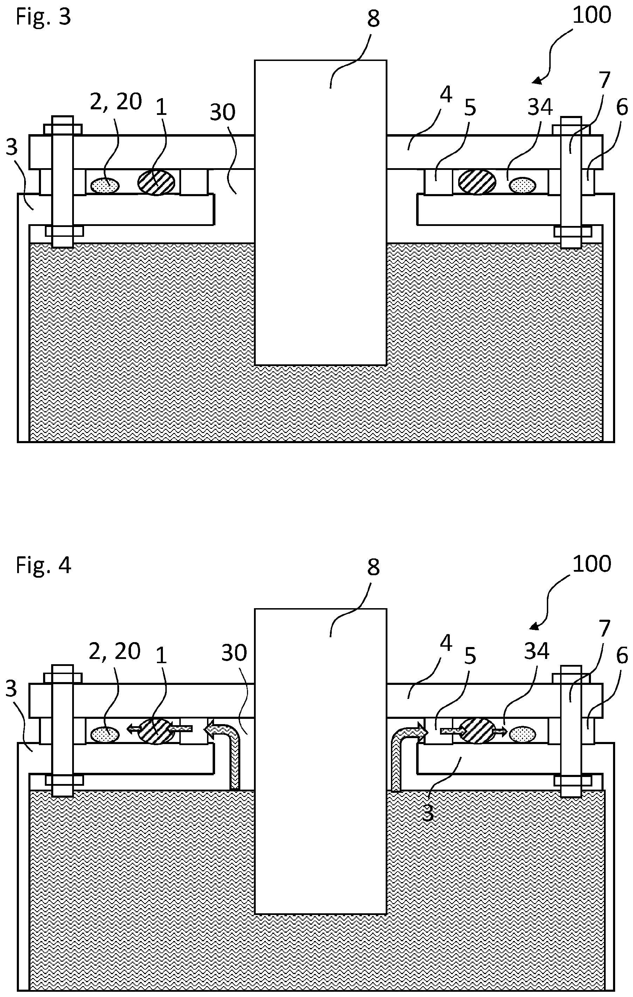

Figure 3 shows a first exemplary embodiment of the electric device 100. The electric device 100 is a power transformer. Figure 3 only shows a section of this power transformer 100. The power transformer 100 comprises a first element 3 in the form of a tank frame. The tank frame 3 is filled with an insulating fluid. An opening 30 is formed in the tank frame 3 which forms a guide-through for a bushing 8. The bushing 8 has a second element 4 which is realized as a flange of the bushing 8. The bushing 8 together with its flange 4 completely covers the opening 30. The flange 4 thereby extends beyond the opening 30 and a gap 34 is formed between the tank frame 3 and the flange 4.

The gap 34 is delimited in vertical direction or first direction, respectively, by the tank frame 3 and the flange 4 and is delimited in lateral direction or a second direction, respectively, by a third element 5 and a fourth element 6. Both elements 5 and 6 are welded bars. The bushing 8 with the flange 4 is fixed to the tank frame 3 by means of bolts 7 extending through the welded bars 6.

In order to prevent the insulating fluid in the tank frame 3 from leaking out of the electric device 100 via the gap 34, a gasket system is arranged in the gap 34. The gasket system may be the gasket system 10 of figures 1 and 2. Thereby, the ring-shaped gasket 1 and the ring-shaped imbibing structure 20 may completely surround the opening 30. The gasket 1 is located closer to the opening 30 than the imbibing structure 20.

As can be seen in figure 3, the thickness of the gasket 1 is chosen such that it extends over the whole height of the gap 34, i.e. adjoins the tank frame 3 on one side and the flange 4 on the other side. This provides a first hurdle for the insulating fluid when it tries to leave the electric device 100 via the gap 34.

The thickness or diameter of the imbibing structure 20 is smaller than the height of the gap 34 so that the imbibing structure 20 only adjoins the tank frame 3.

Figure 4 shows a situation in which a part of the insulating fluid enters into the gap 34. The gasket 1 is configured to seal the gap 34 so that the insulating fluid cannot pass the gasket 1. However, due to aging effects or damage to the gasket 1 or vibrations during operation, a small portion of the insulating fluid may still pass the gasket 1. The imbibing structure 20 is provided for this situation. The imbibing structure 20 would then absorb the insulating fluid and would therefore prevent leakage of the insulating fluid out of the electric device 100.

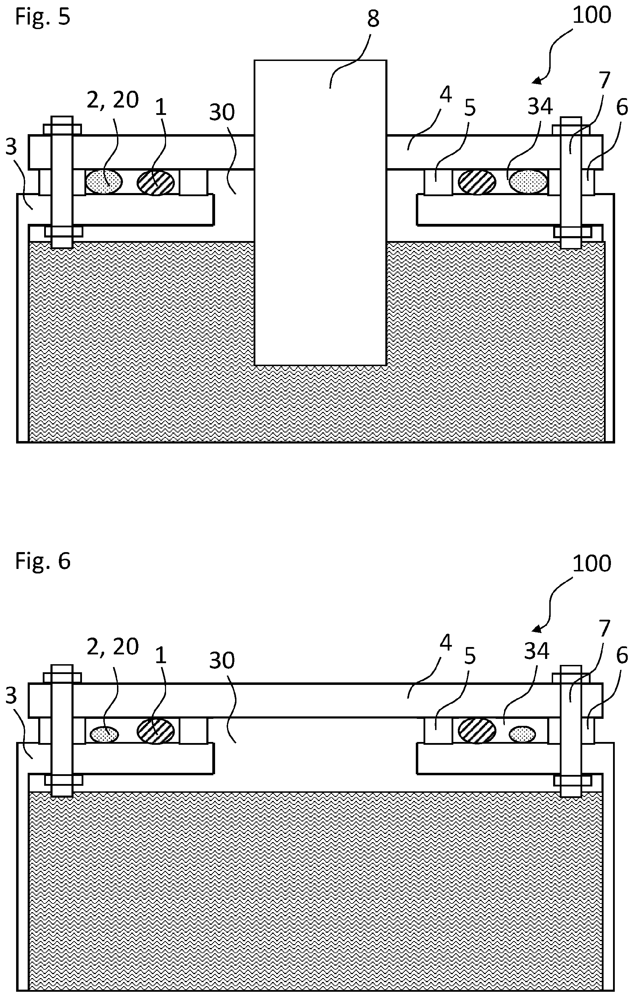

Figure 5 shows the situation after a certain amount of the insulating fluid has passed the gasket 1 and has come into contact with the imbibing structure 20. The imbibing material 2 has absorbed the insulating fluid. Thereby, the size or volume, respectively, of the imbibing material 2 has increased. For example, the beads or fibers have increased their volume up to 27 times their original volume. As a consequence, the imbibing structure 20 has also expanded in the first direction so that the gap 34 is now clogged by the imbibing structure 20. This "repairs" the failure of the gasket 1 to some extent. Thus, the gasket system described herein realizes a self-repairing gasket. It is also not necessary to replace the imbibing structure 30 or the imbibing material 2, respectively, since the capacity for absorbing the insulating fluid is very large. The imbibing material 2 is, for example, not absorbing water so that the imbibing structure 20 would not help to prevent the ingress of moisture.

Figure 6 shows a second exemplary embodiment of the electric device 100. Also here, the electric device 100 is a power transformer. In the present case, however, the opening 20 is not formed for the insertion of a bushing but could be an opening for filling in or extracting the insulating fluid. The opening 30 is covered by a second element 4, which is a cover or lid.

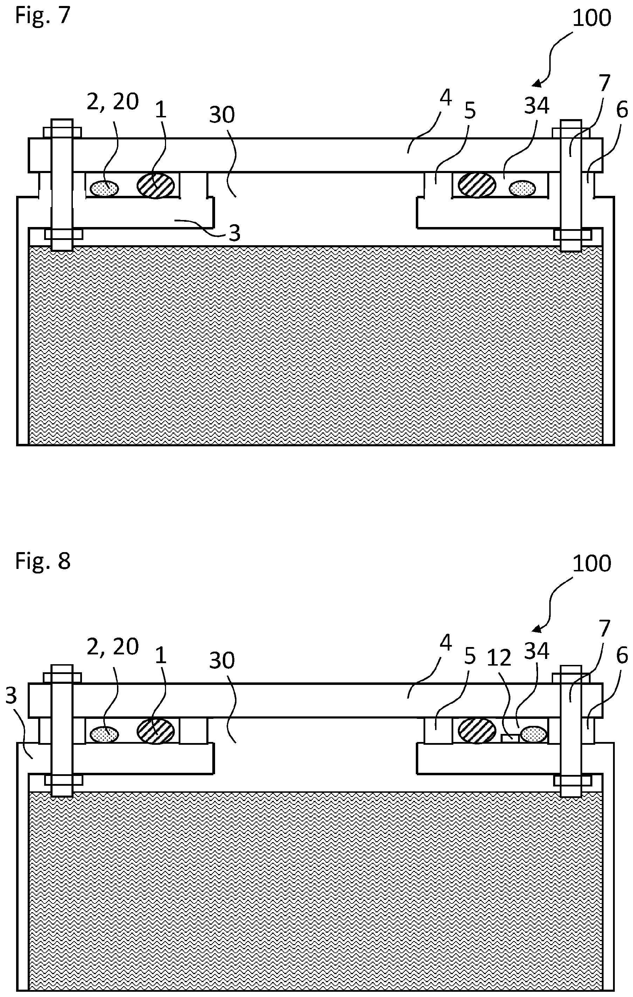

The exemplary embodiment of the electric device 100 of figure 7 deviates from that of figure 6 in that the third and fourth elements, 5 and 6 respectively, that delimit the gap 34 in the second direction are not realized as welded bars but are realized by sides of the tank frame which delimit a machined groove in the tank frame. The first element 3, delimiting the gap 34 in the first direction, is formed by a main body of the tank frame or a bottom side of the machined groove, respectively.

Figure 8 shows an exemplary embodiment of the electric device 100 which is basically the same as that of figure 6. However, inside the gap 34, a sensor 12 or a probe of the sensor 12, respectively, is arranged laterally between the imbibing material 2 and the gasket 1. The sensor 12 is configured to detect the insulating fluid. For example, the sensor 12 is configured to provide an electrical signal which is representative of whether the insulating fluid has been detected or not. This electrical signal can then be used to inform an operator of the electric device 100 whether insulating fluid is between the gasket 1 and the imbibing material 2 or not. An operator can then react accordingly.

The embodiments shown as stated represent exemplary embodiments of the electric device. Therefore, they do not constitute a complete list of all embodiments according to the electric device. Actual electric devices may vary from the embodiments shown in terms of arrangements and elements, for example, within the scope of the appended claims.

### Reference sign list:

- 1: gasket
- 2: imbibing material
- 3: first element / tank frame
- 4: second element / cover / flange
- 5: third element / welded bar / side of machined groove
- 6: fourth element / welded bar / side of machined groove
- 8: bushing
- 7: bolt
- 10: gasket system
- 12: sensor
- 20: imbibing structure
- 30: opening
- 24: gap / groove
- 100: electric device / power transformer

## Claims

1. Electric device (100) with a gasket system (10), the gasket system comprising
- a gasket (1) which is configured to be non-permeable for an insulating fluid used for the operation of the electric device (100), **characterized in that** said gasket system (10) further comprises:
- an imbibing material (2) which is configured to absorb the insulating fluid used for the operation of the electric device (100), wherein
- the gasket (1) and the imbibing material (2) are arranged one after the other in a region of the electric device (100) which is to be sealed so that, if the insulating fluid used for the operation of the electric device (100) passes one of the gasket (1) and the imbibing material (2), the insulating fluid will hit the respective other one of the gasket (1) and the imbibing material (2),
wherein the gasket (1) and the imbibing material (2) are arranged such that the insulating fluid used for the operation of the electric device has to first pass the gasket before it hits the imbibing material,
wherein the imbibing material (1) is configured to absorb the insulating fluid in case of leakage through the gasket (1) and thereby to prevent leakage of the insulating fluid out of the electric device.

2. Electric device (100) according to claim 1, wherein
- the imbibing material (2) is configured to imbibe hydrocarbons.

3. Electric device (100) according to any one of the preceding claims, wherein
- the imbibing material (2) is incorporated in an imbibing structure (20) which can be handled separately from the gasket (1).

4. Electric device (100) according to claim 3, wherein
- the imbibing structure (20) is a fabric containing the imbibing material (2), and
- the imbibing structure (20) is a ribbon.

5. Electric device (100) according to any one of claims 3 or 4, wherein
- the thickness of the imbibing structure (20) is smaller than the thickness of the gasket (1).

6. Electric device (100) according to any one of the preceding claims, further comprising
- a sensor (12) which is configured to detect the insulating fluid.

7. Electric device (100) according to any one of the preceding claims, wherein
- the imbibing material (2) is provided in the form of beads and/or fibers.

8. Electric device (100) according to claim 7, wherein
- the beads are configured to expand their size by at least a factor of 10 when absorbing the insulating fluid and/or
- the fibers are configured to expand their size and solidify when imbibed with the insulating fluid.

9. Electric device (100) according to any one of the preceding claims, wherein
- the gasket (1) comprises or consists of at least one of: cork, rubber.

10. Electric device (100) according to any of the preceding claims, comprising
- a first element (3),
- a second element (4) arranged on the first element (3) and spaced apart from the first element (1) such that a gap (34) is formed between the first (3) and the second (4) element, wherein
- the gasket system (10) is arranged in the gap (34) and configured to prevent the passage of an insulating fluid used for the operation of the electric device (100) through the gap (34).

11. Electric device (100) according to claim 10, wherein
- an opening (30) is formed in the first element (3),
- the first element (3) is configured to receive the insulating fluid during the operation of the electric device (100),
- the gasket (1) is arranged closer to the opening (30) than the imbibing material (2).

12. Electric device (100) according to claim 11, wherein
- the gasket (1) surrounds the opening (30),
- the imbibing material (2) surrounds the opening (30) and the gasket (1).

13. Electric device (100) according to any one of claims 10 to 12, wherein
- in a first direction, the gap (34) is delimited by the first (3) and the second (4) element and, in a second direction, the gap is delimited by a third (5) and a fourth (6) element, wherein the second direction is perpendicular to the first direction,
- in the first direction, the gasket (1) and the imbibing material (2) are arranged between the first (3) and the second (4) element and, in the second direction, the gasket (1) and the imbibing material (2) are arranged between the third (5) and the fourth (6) element.

14. Electric device (100) according to claim 13, wherein
- the electric device (100) is a power transformer,
- the first element (3) is a tank frame or a flange or a cover,
- the second element (4) is a cover, a blind flange or an electric component, e.g. a valve, a bushing or a sensor,
- the third (3) and the fourth (4) element are welded bars or sides delimiting a machined groove.

## Patentansprüche

1. Elektrische Vorrichtung (100) mit einem Dichtungssystem (10), wobei das Dichtungssystem umfasst:
- eine Dichtung (1), die dazu ausgelegt ist, für ein Isolierfluid, das für den Betrieb der elektrischen Vorrichtung (100) verwendet wird, undurchlässig zu sein, **dadurch gekennzeichnet, dass** das Dichtungssystem (10) ferner Folgendes umfasst:
- ein aufsaugendes Material (2), das dazu ausgelegt ist, das für den Betrieb der elektrischen Vorrichtung (100) verwendete Isolierfluid zu absorbieren, wobei
- die Dichtung (1) und das aufsaugende Material (2) in einer abzudichtenden Region der elektrischen Vorrichtung (100) hintereinander angeordnet sind, so dass, wenn das für den Betrieb der elektrischen Vorrichtung (100) verwendete Isolierfluid durch eines von der Dichtung (1) oder dem aufsaugenden Material (2) hindurchtritt, das Isolierfluid auf das jeweils andere von der Dichtung (1) und dem aufsaugenden Material (2) trifft,
wobei die Dichtung (1) und das aufsaugende Material (2) so angeordnet sind, dass das für den Betrieb der elektrischen Vorrichtung verwendete Isolierfluid zuerst durch die Dichtung hindurchtreten muss, bevor es auf das aufsaugende Material trifft,
wobei das aufsaugende Material (1) dazu ausgelegt ist, das Isolierfluid im Fall einer Leckage durch die Dichtung (1) zu absorbieren und dadurch Leckage des Isolierfluids aus der elektrischen Vorrichtung heraus zu verhindern.

2. Elektrische Vorrichtung (100) nach Anspruch 1, wobei
- das aufsaugende Material (2) zum Aufsaugen von Kohlenwasserstoffen ausgelegt ist.

3. Elektrische Vorrichtung (100) nach einem der vorhergehenden Ansprüche, wobei
- das aufsaugende Material (2) in eine aufsaugende Struktur (20) eingebaut ist, die getrennt von der Dichtung (1) gehandhabt werden kann.

4. Elektrische Vorrichtung (100) nach Anspruch 3, wobei
- die aufsaugende Struktur (20) ein Textil ist, welches das aufsaugende Material (2) enthält, und
- die aufsaugende Struktur (20) ein Band ist.

5. Elektrische Vorrichtung (100) nach einem der Ansprüche 3 oder 4, wobei
- die Dicke der aufsaugenden Struktur (20) kleiner als die Dicke der Dichtung (1) ist.

6. Elektrische Vorrichtung (100) nach einem der vorhergehenden Ansprüche, ferner umfassend:
- einen Sensor (12), der dazu ausgelegt ist, das Isolierfluid zu detektieren.

7. Elektrische Vorrichtung (100) nach einem der vorhergehenden Ansprüche, wobei
- das aufsaugende Material (2) in Form von Perlen und/oder Fasern bereitgestellt wird.

8. Elektrische Vorrichtung (100) nach Anspruch 7, wobei
- die Perlen dazu ausgelegt sind, ihre Größe bei der Absorption des Isolierfluids um mindestens den Faktor 10 zu expandieren, und/oder
- die Fasern dazu ausgelegt sind, ihre Größe zu expandieren und zu erstarren, wenn sie die Isolierflüssigkeit aufsaugen.

9. Elektrische Vorrichtung (100) nach einem der vorhergehenden Ansprüche, wobei
- die Dichtung (1) mindestens eines von Kork oder Gummi umfasst oder daraus besteht.

10. Elektrische Vorrichtung (100) nach einem der vorhergehenden Ansprüche, umfassend:
- ein erstes Element (3);
- ein zweites Element (4), das auf dem ersten Element (3) angeordnet ist und von dem ersten Element (1) beabstandet ist, so dass ein Spalt (34) zwischen dem ersten (3) und dem zweiten (4) Element gebildet wird, wobei
- das Dichtungssystem (10) in dem Spalt (34) angeordnet ist und dazu ausgelegt ist, den Durchtritt eines Isolierfluids, das für den Betrieb der elektrischen Vorrichtung (100) verwendet wird, durch den Spalt (34) zu verhindern.

11. Elektrische Vorrichtung (100) nach Anspruch 10, wobei
- eine Öffnung (30) in dem ersten Element (3) gebildet ist,
- das erste Element (3) dazu ausgelegt ist, das Isolierfluid während des Betriebs der elektrischen Vorrichtung (100) aufzunehmen,
- die Dichtung (1) näher an der Öffnung (30) angeordnet ist als das aufsaugende Material (2).

12. Elektrische Vorrichtung (100) nach Anspruch 11, wobei
- die Dichtung (1) die Öffnung (30) umgibt,
- das aufsaugende Material (2) die Öffnung (30) und die Dichtung (1) umgibt.

13. Elektrische Vorrichtung (100) nach einem der Ansprüche 10 bis 12, wobei
- der Spalt (34) in einer ersten Richtung durch das erste (3) und das zweite (4) Element begrenzt wird, und der Spalt in einer zweiten Richtung durch ein drittes (5) und ein viertes (6) Element begrenzt wird, wobei die zweite Richtung rechtwinklig zu der ersten Richtung ist,
- die Dichtung (1) und das aufsaugende Material (2) in der ersten Richtung zwischen dem ersten (3) und dem zweiten (4) Element angeordnet sind, und die Dichtung (1) und das aufsaugende Material (2) in der zweiten Richtung zwischen dem dritten (5) und dem vierten (6) Element angeordnet sind.

14. Elektrische Vorrichtung (100) nach Anspruch 13, wobei
- die elektrische Vorrichtung (100) ein Leistungstransformator ist,
- das erste Element (3) ein Tankrahmen oder ein Flansch oder eine Abdeckung ist,
- das zweite Element (4) eine Abdeckung, ein Blindflansch oder eine elektrische Komponente ist, z. B. ein Ventil, eine Durchführung oder ein Sensor,
- das dritte (3) und das vierte (4) Element geschweißte Stäbe oder Seiten sind, die eine gefräste Nut begrenzen.

## Revendications

1. Dispositif électrique (100) avec un système de joint d'étanchéité (10), le système de joint d'étanchéité comprenant
- un joint d'étanchéité (1) qui est configuré pour être imperméable à un fluide isolant utilisé pour le fonctionnement du dispositif électrique (100), **caractérisé en ce que** ledit système de joint d'étanchéité (10) comprend en outre :
- un matériau imbibant (2) qui est configuré pour absorber le fluide isolant utilisé pour le fonctionnement du dispositif électrique (100), dans lequel
- le joint d'étanchéité (1) et le matériau imbibant (2) sont agencés l'un à la suite de l'autre dans une région du dispositif électrique (100) qui doit être étanchéisée de sorte que, si le fluide isolant utilisé pour le fonctionnement du dispositif électrique (100) passe un élément parmi le joint d'étanchéité (1) et le matériau imbibant (2), le fluide isolant heurtera l'autre élément respectif parmi le joint d'étanchéité (1) et le matériau imbibant (2),
dans lequel le joint d'étanchéité (1) et le matériau imbibant (2) sont agencés de telle sorte que le fluide isolant utilisé pour le fonctionnement du dispositif électrique doive passer d'abord le joint d'étanchéité avant qu'il heurte le matériau imbibant,
dans lequel le matériau imbibant (1) est configuré pour absorber le fluide isolant en cas de fuite à travers le joint d'étanchéité (1) et empêcher ainsi une fuite du fluide isolant hors du dispositif électrique.

2. Dispositif électrique (100) selon la revendication 1, dans lequel
- le matériau imbibant (2) est configuré pour imbiber des hydrocarbures.

3. Dispositif électrique (100) selon l'une quelconque des revendications précédentes, dans lequel
- le matériau imbibant (2) est incorporé dans une structure imbibante (20) qui peut être manipulée séparément du joint d'étanchéité (1).

4. Dispositif électrique (100) selon la revendication 3, dans lequel
- la structure imbibante (20) est un tissu contenant le matériau imbibant (2), et
- la structure imbibante (20) est un ruban.

5. Dispositif électrique (100) selon l'une quelconque des revendications 3 ou 4, dans lequel
- l'épaisseur de la structure imbibante (20) est inférieure à l'épaisseur du joint d'étanchéité (1).

6. Dispositif électrique (100) selon l'une quelconque des revendications précédentes, comprenant en outre
- un capteur (12) configuré pour détecter le fluide isolant.

7. Dispositif électrique (100) selon l'une quelconque des revendications précédentes, dans lequel
- le matériau imbibant (2) est fourni sous la forme de billes et/ou de fibres.

8. Dispositif électrique (100) selon la revendication 7, dans lequel
- les billes sont configurées pour expanser leur dimension d'au moins un facteur 10 lors de l'absorption du fluide isolant et/ou
- les fibres sont configurées pour expanser leur taille et se solidifier lorsqu'elles sont imbibées avec le fluide isolant.

9. Dispositif électrique (100) selon l'une quelconque des revendications précédentes, dans lequel
- le joint d'étanchéité (1) comprend ou est constitué d'au moins un élément parmi : liège, caoutchouc.

10. Dispositif électrique (100) selon l'une quelconque des revendications précédentes, comprenant
- un premier élément (3),
- un deuxième élément (4) agencé sur le premier élément (3) et espacé du premier élément (1) de sorte qu'un intervalle (34) soit formé entre le premier (3) et le deuxième (4) élément, dans lequel
- le système de joint d'étanchéité (10) soit agencé dans l'intervalle (34) et configuré pour empêcher le passage d'un fluide isolant utilisé pour le fonctionnement du dispositif électrique (100) à travers l'intervalle (34).

11. Dispositif électrique (100) selon la revendication 10, dans lequel
- une ouverture (30) est formée dans le premier élément (3),
- le premier élément (3) est configuré pour recevoir le fluide isolant pendant le fonctionnement du dispositif électrique (100),
- le joint d'étanchéité (1) est agencé plus proche de l'ouverture (30) que le matériau imbibant (2).

12. Dispositif électrique (100) selon la revendication 11, dans lequel
- le joint d'étanchéité (1) entoure l'ouverture (30),
- le matériau imbibant (2) entoure l'ouverture (30) et le joint d'étanchéité (1).

13. Dispositif électrique (100) selon l'une quelconque des revendications 10 à 12, dans lequel
- dans une première direction, l'intervalle (34) est délimité par le premier (3) et le deuxième (4) élément et, dans une deuxième direction, l'intervalle est délimité par un troisième (5) et un quatrième (6) éléments, la deuxième direction étant perpendiculaire à la première direction,
- dans la première direction, le joint d'étanchéité (1) et le matériau imbibant (2) sont agencés entre le premier (3) et le deuxième (4) élément et dans la deuxième direction, le joint d'étanchéité (1) et le matériau imbibant (2) sont agencés entre le troisième (5) et le quatrième (6) élément.

14. Dispositif électrique (100) selon la revendication 13, dans lequel
- l'appareil électrique (100) est un transformateur de puissance,
- le premier élément (3) est une ossature de cuve ou une bride ou un couvercle,
- le second élément (4) est un couvercle, une bride borgne ou un composant électrique, par ex. une vanne, une douille ou un capteur,
- le troisième (3) et le quatrième (4) élément sont des barres ou côtés soudés délimitant une rainure usinée.
